# EUROPÄISCHE PATENTANMELDUNG

(11) **EP 1 491 902 A1**
(43) Veröffentlichungstag der Anmeldung: **29.12.2004**
(21) Anmeldenummer: 04008835.3
(22) Anmeldetag: 14.04.2004
(51) Int. Cl.: G01R 15/20

(54) **Stromsensor für ein Steuergerät**

(30) Priorität: 24.06.2003 DE 10328207
(71) Anmelder: ROBERT BOSCH GMBH, 70442 Stuttgart (DE)
(72) Erfinder: Knapp, Martin, 72138 Kirchentellinsfurt (DE); Holzwarth, Gerhard, 72793 Pfullingen (DE); Zein, Walter, 72555 Metzingen (DE)

(57) **Zusammenfassung**

Die Erfindung betrifft einen Stromsensor (2) mit einem Joch (4; 5) mit einem Luftspalt, einer in dem Luftspalt angeordneten Magnetfeldsonde (6) und einem Schaltungsträger (1), auf dem die Magnetfeldsonde (6) befestigt ist. Die Magnetfeldsonde (6) ist eine Aussparung des Schaltungsträgers (1) überbrückend befestigt, wobei ein Magnetfluss des Jochs (4; 5) in der Aussparung senkrecht zum Schaltungsträger (1) orientiert ist.

## Beschreibung

### Stand der Technik

Erfindungsgegenstand ist ein Stromsensor mit einem Joch mit einem Luftspalt, einer in dem Luftspalt angeordneten Magnetfeldsonde und einem Schaltungsträger, auf dem die Magnetfeldsonde befestigt ist. Ein solcher Stromsensor kann z.B. in einem elektrischen Steuergerät, insbesondere für ein Kraftfahrzeug zum Einsatz kommen und einen integralen Bestandteil eines solchen Geräts bilden.

Ein Stromsensor zur Messung eines in einem Leiter fließenden elektrischen Stromes ist in der EP 0 815 456 B1 beschrieben. Dieser Stromsensor umfasst ein magnetisches Joch mit einem Luftspalt sowie eine in dem Luftspalt angeordnete quaderförmige Magnetfeldsonde und einen Schaltungsträger, der einen elektrischen Schaltkreis trägt, welcher zur Verstärkung eines Ausgangssignals der genannten Magnetfeldsonde ausgebildet ist, wobei der Schaltungsträger einen ausgeschnittenen Bereich aufweist. Der ausgeschnittene Bereich dient der Aufnahme des um das Joch zu einer Spule gewickelten Leiters.

Beim beschriebenen Stromsensor ist die quaderförmige Magnetfeldsonde mit einer Schmalseite an dem Schaltungsträger befestigt und steht hochkant und senkrecht von dem Schaltungsträger ab, damit sie in den Luftspalt des Jochs eingreifen kann. Dabei ist das Joch auf senkrecht von dem Schaltungsträger abstehende Stifte aufgesteckt. Diese Konstruktion macht den Stromsensor anfällig für mechanische Erschütterungen bzw. Belastungen, weil eine kleine Bewegung des Jochs relativ zum Schaltungsträger ausreicht, um die Magnetfeldsonde von dem Schaltungsträger abzubrechen oder zumindest die elektrischen Kontakte zwischen ihr und dem Schaltungsträger zu beschädigen.

### Vorteile der Erfindung

Durch die Erfindung, wie in Anspruch 1 definiert, wird ein Magnetfeldsensor geschaffen, der besonders robust und unempfindlich gegen Erschütterung oder andere Arten von externer mechanischer Krafteinwirkung ist.

Dank der die Aussparung überbrückenden Befestigung der Magnetfeldsonde sind beim erfindungsgemäßen Stromsensor sehr hohe Hebelmomente erforderlich, um die Magnetfeldsonde, bei der es sich vorzugsweise um eine Hall-Sonde handelt, von dem Schaltungsträger loszubrechen. Da die Magnetfeldsonde eine Aussparung des Schaltungsträgers überbrückt, wird von dem Schaltungsträger weder ein Magnetfluss durch die Sonde noch deren Messergebnis beeinträchtigt.

Nach einer bevorzugten Ausführung des Stromsensors taucht das Joch in die Aussparung des Schaltungsträgers ein, um so die Breite des Luftspaltes des Jochs zu minimieren.

Dabei kann die Aussparung ein Fenster in dem Schaltungsträger sein.

Die Aussparung des Schaltungsträgers kann aber auch randoffen sein.

Beim Joch kann es sich um ein einteiliges Joch handeln.

Bevorzugt wird jedoch ein mehrteiliges, insbesondere ein zweiteiliges Joch, da sich mit einem solchen ein Einbau des Stromsensors in ein Gehäuse besonders einfach und schnell gestaltet, weil das Joch nicht sofort als Ganzes in das Gehäuse eingesetzt zu werden braucht, sondern zunächst nur ein jeweiliges Teilsegment. Man gewinnt dadurch Handlungsraum zum Einbau der anderen Komponenten, da das Joch als Ganzes nicht störend im Wege steht.

Das mehrteilige Joch kann eine Nut-Feder-Verbindung aufweisen.

Bei einer weiteren Ausführung durchsetzt ein Leiter das Joch geradlinig. Das Joch erfasst das von dem Leiter erzeugte Magnetfeld und konzentriert es an der Magnetfeldsonde. Gleichzeitig schirmt er die außerhalb des Jochs liegende Steuerschaltung gegen das Magnetfeld des Leiters ab. Somit kann es sich beim Leiter beispielsweise auch um eine robuste Stromschiene handeln, die hohe elektrische Stromstärken führen kann. Dabei ist es möglich, den Leiter am Gehäuse verankert vorzusehen.

Bei einer besonders bevorzugten Weiterbildung weist das Joch im Luftspalt einen Zapfen auf, der in den Ausschnitt des Schaltungsträgers eingreift.

Ebenso besonders bevorzugt trägt der Schaltungsträger eine Weiterverarbeitungsschaltung zur Verarbeitung von Messergebnissen, die von der Magnetfeldsonde stammen. Bei der Weiterverarbeitungsschaltung kann es sich zum Beispiel um ein Steuergerät eines Kraftfahrzeugs handeln. Bei einem solchen Steuergerät kann der Stromsensor z.B. zum Überwachen des Ladungszustand einer Batterie durch Messung eines Batteriestromes dienen. Eine solche Überwachung ist besonders bei sogenannten "x-by-Wire"-Kraftfahrzeugen wichtig, bei denen vitale Funktionen wie Lenkung, Bremse, Kupplung oder Gas elektrisch gesteuert sind, da hier eine Störung der Batterie zum Ausfall der Funktionen führen kann und daher eine Funktionsschwäche der Batterie erkannt werden muss, bevor es zu einem Ausfall kommt.

Vorteilhaft ist ein Joch, das eine Spule für eine Entmagnetisierung des Jochs aufweist. Ist das Joch aus Teilsegmenten aufgebaut, dann kann die Spule an einem der Teilsegmente angeordnet sein.

Die Erfindung wird nachfolgend anhand eines besonders bevorzugten Ausführungsbeispiels erläutert. Dabei zeigen die Figuren:
- Fig. 1: einen Querschnitt durch ein Steuergerät mit einem erfindungsgemäßen Stromsensor;
- Fig. 2: Komponenten des Steuergeräts und des erfindungsgemäßen Stromsensors in räumlicher Darstellung; und
- Fig. 3: Joch und Schaltungsträger einer weiteren Ausführung des Stromsensors.

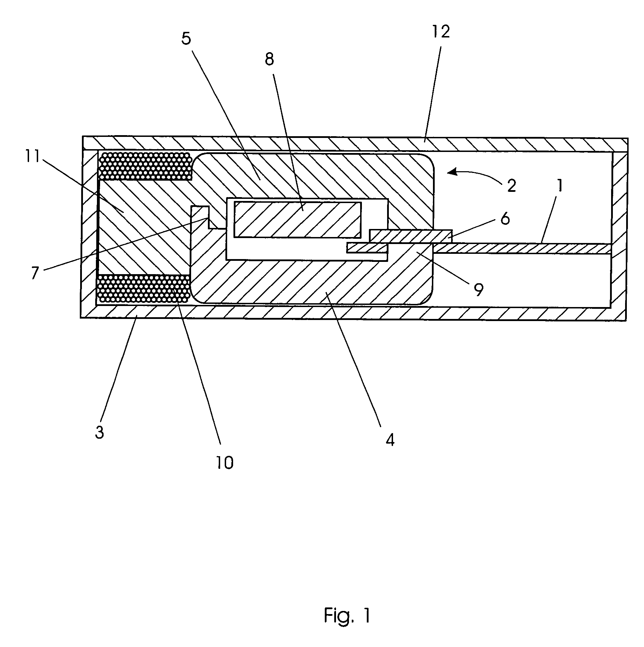

Ein Querschnitt durch ein Steuergerät mit einem erfindungsgemäßen Stromsensor 2 ist in Fig. 1 dargestellt. Der Stromsensor 2 umfasst ein Joch aus einem ferromagnetischen Material wie etwa ferritgefülltem Silikon, hier zweiteilig aufgebaut aus einem unteren Teilsegment 4 und einem oberen Teilsegment 5, sowie eine Hall-Sonde 6 als Magnetfeldsonde, die auf einem Schaltungsträger 1 befestigt ist und einen Luftspalt des Jochs ausfüllt. Der Schaltungsträger 1 ist von beliebiger an sich bekannter Art, z.B. eine Leiterplatte, ein Metall- oder Keramiksubstrat. Das untere Teilsegment 4 und das obere Teilsegment 5 des Jochs sind mittels einer Nut-Feder-Verbindung 7 zusammengefügt. Am oberen Teilsegment 5 ist auf der Seite der Nut-Feder-Verbindung 7 des Jochs eine Spule 10 vorgesehen, die um einen Vorsprung 11 des oberen Teilsegments 5 gewickelt ist. Der Nut-Feder-Verbindung 7 gegenüberliegend ist das Joch vom Luftspalt unterbrochen, der von der Hall-Sonde 6 ausgefüllt ist. Auf dem Schaltungsträger 1 befindet sich außer der Hall-Sonde 6 eine Steuerschaltung. Ein Gehäuse 3 mit einem Deckel 12 nimmt den Stromsensor 2 auf.

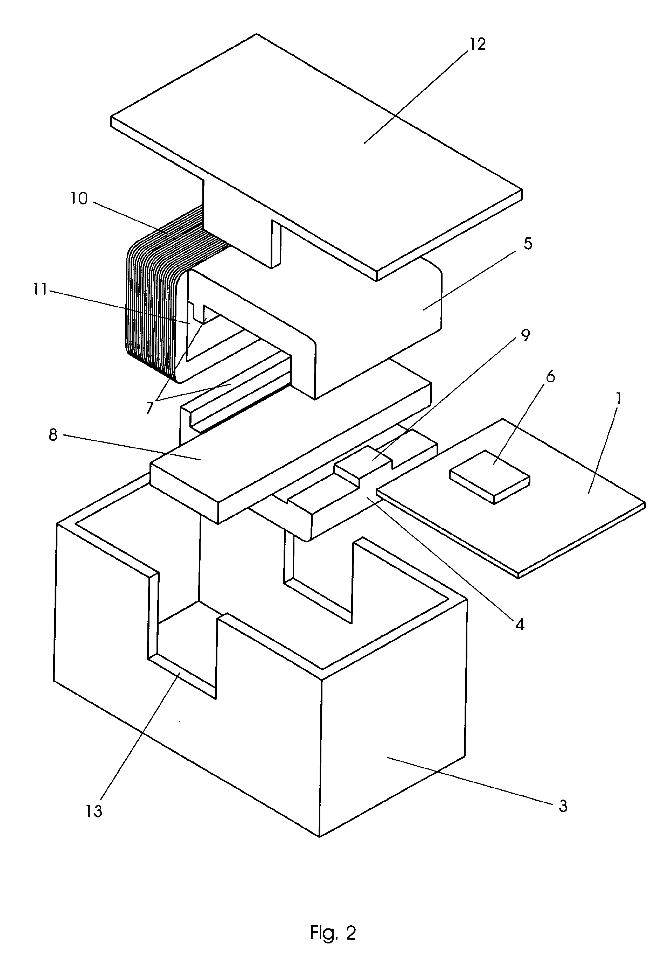

Schließlich wird das Joch von einem Leiter 8 durchquert, bei dem es sich um eine gerade Leiterschiene zur Führung von hohen Stromstärken handelt, und der beidseitig aus dem Gehäuse 3 ragt. Dabei ist der Leiter 8 in seitlichen Ausnehmungen 13 des Gehäuses 3 unterstützt, die in der Fig. 2 zu sehen sind.

Fig. 2 zeigt das Steuergerät der Fig. 1 in räumlicher Explosionsdarstellung. Wie hier zu sehen ist, weist das untere Teilsegment 4 an einer der Nut-Feder-Verbindung 7 gegenüberliegenden Seite, an der sich im zusammengefügten Zustand der beiden Teilsegmente 4 und 5 der Luftspalt befindet, einen Zapfen 9 auf. In dem Schaltungsträger 1 ist eine dem Zapfen 9 entsprechende Aussparung vorgesehen, so dass der Zapfen 9 im zusammengebauten Zustand des Stromsensors 2 in diese Aussparung eingreift und den Schaltungsträger 1 mit dem Zapfen 9 verhakt. Außerdem bewirkt der Zapfen, da er den Luftspalt lokal verengt, eine Bündelung des vom in der Leiterschiene 8 fließenden Strom in dem Joch induzierten Magnetfelds, so dass die Hall-Sonde 6, die im Luftspalt direkt über dieser Aussparung bzw. dem Zapfen 9 auf dem Schaltungsträger 1 angeordnet ist, einem starken Magnetfeld ausgesetzt ist. Die Hall-Sonde 6 überbrückt die Aussparung des Schaltungsträgers 1 und ist an wenigstens zwei Seiten der Aussparung durch Löten, Kleben oder auf andere geeignete Weise an dem Schaltungsträger 1 befestigt.

Der Leiter 8, dessen elektrischer Stromfluss gemessen werden soll, ist innerhalb des Gehäuses 3 von den Teilsegmenten 4 und 5 umschlossen. Diese erstrecken sich entlang des Leiters über die gesamte Breite des Innenraums des Gehäuses 3 und schirmen so die außerhalb des Luftspalts liegenden Teile des Schaltungsträgers 1 weitestgehend gegen das vom Leiter 8 induzierte Magnetfeld ab. Auf diese Weise ist die auf dem Schaltungsträger 1 befindliche Steuerschaltung vor Störeinflüssen durch den Strom im Leiter 8 geschützt.

Eine Restmagnetisierung, die nach dem Messen eines starken Stroms im Joch zurückbleiben kann, kann mit Hilfe der Spule 10 beseitigt werden, die, wenn sie mit einem Wechselstrom versorgt wird, den Restmagnetismus im Joch eliminiert. Die Steuerschaltung kann die Entmagnetisierung als selbsttätig zu einem geeigneten Zeitpunkt, z.B. vor dem Umschalten in einen empfindlicheren Strommessbereich, selbsttätig durchführen.

Beim Zusammenbau des Steuergeräts wird zunächst das untere Teilsegment 4 in das Gehäuse 3 eingesetzt. Anschließend wird der Schaltungsträger 1 mit der auf ihm angeordneten Hall-Sonde 6 derart im Gehäuse 3 eingesetzt, dass der Zapfen 9 in die Aussparung des Schaltungsträgers 1 eingreift. Nach Einsetzen des Leiters 8 wird das obere Teilsegment 5 mit der Spule 10 auf das untere Teilsegment 4 aufgesetzt und über die Nut-Feder-Verbindung 7 mit diesem verbunden. Es handelt sich dabei um einen einfachen Fügeprozess. Im eingesetzten Zustand sind die beiden Teilsegmente 4 und 5 sowie die Spule 10 durch das Gehäuse 3 fixiert und gehalten.

Schließlich wird der Deckel 12 aufgesetzt und das Gehäuse 3 verschlossen.

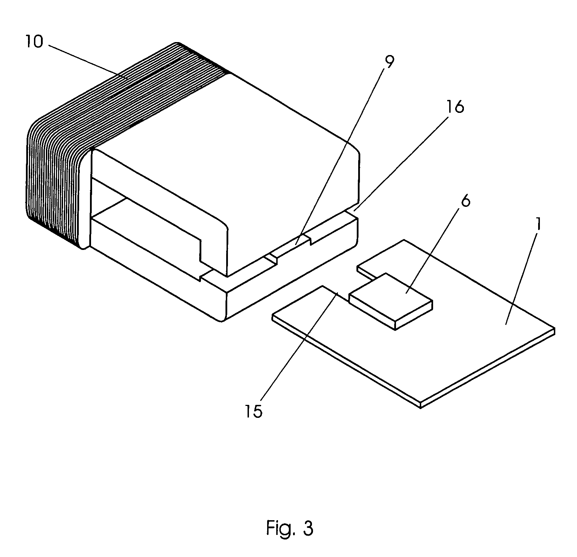

Fig. 3 zeigt ein einstückiges Joch 14 und einen Schaltungsträger 1 einer weiteren Ausführung eines erfindungsgemäßen Stromsensors. Auf der Schaltungsträger ist wie im zuvor beschriebenen Beispiel eine Hall-Sonde 6 befestigt, die eine Aussparung 15 in dem Schaltungsträger 1 überbrückt, jedoch ist diese Aussparung 15 im Unterschied zum zuvor beschriebenen Beispiel zum Joch hin randoffen. Diese Ausgestaltung ermöglicht es, den Schaltungsträger 1 mit der Hall-Sonde 6 von der Seite her in den Luftspalt 16 des Jochs so einzuschieben, dass der im Luftspalt 16 vorgesehene Zapfen 9 wie im vorherigen Beispiel in die Aussparung 15 eingreift. Es ist selbstverständlich auch möglich, den in Fig. 3 gezeigten Schaltungsträger mit randoffener Aussparung 15 mit einem zweiteiligen Joch, wie in den Figs. 1 und 2 gezeigt, zu kombinieren.

Im Betrieb des Steuergeräts wird der Leiter 8 von einem elektrischen Strom hoher Stromstärke durchflossen. Der Leiter 8 ist dabei von einem Magnetfeld umgeben, das von den weichmagnetischen Teilsegmenten 4 und 5 des Jochs geführt wird. Der Magnetfluss wird im Joch geführt und durchsetzt senkrecht sowohl den Luftspalt als auch den Schaltungsträger 1 und die Hall-Sonde 6. Die Hall-Sonde 6 detektiert den Magnetfluss und gibt das Ergebnis an die Steuerschaltung weiter. Eine Änderung der Stromstärke bewirkt daher eine direkte Änderung des von der Hall-Sonde 6 detektierten Magnetflusses und liefert der Steuerschaltung die Information, aufgrund der sie in vorprogrammierter Weise reagiert.

## Patentansprüche

1. Stromsensor (2) mit einem Joch (4; 5) mit einem Luftspalt, einer in dem Luftspalt angeordneten Magnetfeldsonde (6) und einem Schaltungsträger (1), auf dem die Magnetfeldsonde (6) befestigt ist, **dadurch gekennzeichnet, dass** die Magnetfeldsonde (6) eine Aussparung des Schaltungsträgers (1) überbrückend befestigt ist und dass ein Magnetfluss des Jochs (4; 5) in der Aussparung senkrecht zum Schaltungsträger (1) orientiert ist.

2. Stromsensor (2) nach Anspruch 1, **dadurch gekennzeichnet, dass** das Joch (4; 5) in die Aussparung des Schaltungsträgers (1) eintaucht.

3. Stromsensor (2) nach Anspruch 1 oder 2, **dadurch gekennzeichnet, dass** die Aussparung ein Fenster in dem Schaltungsträger (1) ist.

4. Stromsensor (2) nach Anspruch 1 oder 2, **dadurch gekennzeichnet, dass** die Aussparung des Schaltungsträgers (1) randoffen ist.

5. Stromsensor (2) nach einem der vorhergehenden Ansprüche, **gekennzeichnet durch** ein einteiliges Joch (4; 5).

6. Stromsensor (2) nach einem der Ansprüche 1 bis 4, **gekennzeichnet durch** ein zweiteiliges Joch (4; 5).

7. Stromsensor (2) nach Anspruch 6, **dadurch gekennzeichnet, dass** das Joch (4; 5) eine Nut-Feder-Verbindung (7) aufweist.

8. Stromsensor (2) nach einem der vorhergehenden Ansprüche, **dadurch gekennzeichnet, dass** ein Leiter (8) das Joch (4; 5) geradlinig durchsetzt.

9. Stromsensor (2) nach Anspruch 8, **dadurch gekennzeichnet, dass** das Joch (4; 5) einen in die Aussparung eingreifenden Zapfen (9) trägt und in einer Richtung des Leiters (8) über den Zapfen (9) hinaus verbreitert ist.

10. Stromsensor (2) nach einem der vorhergehenden Ansprüche, **dadurch gekennzeichnet, dass** der Schaltungsträger (1) eine Weiterverarbeitungsschaltung zur Verarbeitung von Messergebnissen, die von der Magnetfeldsonde (6) stammen, umfasst.

11. Stromsensor (2) nach einem der Ansprüche 2 bis 8, **dadurch gekennzeichnet, dass** das Joch (4; 5) eine Spule (10) für eine Entmagnetisierung des Jochs (4; 5) aufweist.
